# EUROPEAN PATENT SPECIFICATION

(11) **EP 2 943 673 B1**
(45) Date of publication and mention of the grant of the patent: **28.06.2017**
(21) Application number: 13859596.2
(22) Date of filing: 26.11.2013
(51) Int. Cl.: F02G 5/00, H01L 31/00

(54) **AN ENGINE FURNISHED WITH A SYSTEM OF SOLAR PANELS TO WHICH THE LIGHT PRODUCED BY THE COMBUSTION FOR THE GENERATION OF ELECTRIC CURRENT IS TRANSMITTED**
MOTOR MIT EINEM SYSTEM AUS SOLARPANEELEN, ZU DEM DAS AUS DER VERBRENNUNG ZUR STROMERZEUGUNG ERZEUGTE LICHT ÜBERTRAGEN WIRD
MOTEUR COMPORTANT UN SYSTÈME DE PANNEAUX SOLAIRES AUQUEL EST TRANSMISE LA LUMIÈRE PRODUITE PAR LA COMBUSTION POUR LA GÉNÉRATION DE COURANT ÉLECTRIQUE

(30) Priority: 10.01.2013 IT FI20130007
(43) Date of publication of application: 18.11.2015
(73) Proprietor: Dallavalle, Francesco, 25030 Urago D'Oglio (BS) (IT)
(72) Inventor: Dallavalle, Francesco, 25030 Urago D'Oglio (BS) (IT)
(74) Representative: Emmi, Mario
(86) International application number: PCT/IB2013/060404
(87) International publication number: WO 2014/114999

(56) References cited:
- DE-A1-102008 033 185
- DE-A1-102008 035 826
- DE-A1-102008 042 927
- JP-A- 2001 082 167
- US-A- 5 129 223

## Description

### Technical field

The present invention refers to the technical field relative to internal combustion engines.

In particular, the invention refers to an innovative technology that allows to recover luminous energy from the burst that takes place in the engine during the combustion.

### Background art

Internal combustion engines for vehicles in general such as cars, motor-scooters, etc., have long been known. The working principle of an internal combustion engine is very simple and is based on the theoretical "Otto" cycle that foresees two isochoric thermo-dynamic phases and two adiabatic thermo-dynamic phases.

In a very schematic manner, the internal combustion engine foresees a combustion chamber formed by a cylinder having an inlet for a mixture of air-fuel, an outlet for the residues of the combustion and a spark plug that triggers a spark plug in the combustion chamber. The combustion chamber is therefore superiorly delimited by the walls of the cylinder and inferiorly by a piston mounted slidingly inside the cylinder and, in turn, connected to a piston rod connected, by the opposite end, to a rotatory axis. The alternate motion of the piston inside the cylinder is transformed in rotation of the rotatory axis through a transmission of the motion that takes place by means of the interposed piston rod. The alternate motion of the piston causes a rotation of the rotatory axis through the piston rod.

The cycle foresees the phases of:
- Compression of the mixture injected in the cylinder; this phase is the first adiabatic phase without thermal exchange with the outside;
- The burst follows through a spark created by the spark plug, with an isochoric transformation at constant volume that causes an important rise of the pressure;
- An adiabatic expansion follows with consequent translation of the cylinder towards the bottom that thus activates the piston rod;
- Return of the cylinder in initial position and therefore expulsion of the combusted gases;
- Retake of the cycle with a new burst following the injection of new air-fuel mixture.

This is naturally a basic working cycle which is however at the base of all the internal combustion engines.

In the current state of the art, technologies are present that allow energy saving and therefore energy recovery. The whole naturally translates into fuel saving, and therefore into greater environmental respect and cost reduction for the user.

One of these technologies is for example described in International patent application WO2010061243, wherein a fan is described placed at the front of the vehicle and which is kinematically connected to the engine. In this manner, during the advancement of the vehicle thanks to the engine, the fan is hit by the air flow and enters in action helping the engine itself, therefore reducing the consumption.

Nevertheless, this solutions is particularly complex from the mechanic point of view since it requires an integration of a mechanical structure that must be somehow collaborating with the engine. Moreover, the production of "auxiliary" engine, let's say, is linked to the motion of the vehicle and to its speed. If the engine is switched on, but the vehicle is still or in motion at reduced speed, it is not possible to obtain energy.

Other alternative solutions are already present in the market. For example, the classical internal combustion engine is put side by side to electric engines. In some vehicles the electric engine, even if for short path, can substitute the internal combustion one. Nevertheless, it is clear that the electric engine requires a periodic recharge and the recharge implies a production of current. In that sense, all that continues to reflect on the final user with costs to bear and, above all, as it is well known, the production of electric current has almost always a negative environmental impact. DE 10 2008 033185 A1 and JP 2001 082167 disclose known cylinder assemblies, according to the preamble of claim 1.

### Disclosure of invention

It is therefore the aim of the present invention to provide an engine, and a relative cylinder assembly for an engine, that solve at least in part said technical inconveniences.

In particular, it is the aim of the present invention to provide an engine, and a relative cylinder assembly for an engine, capable of significantly reducing the consumption and therefore of contributing to the reduction of costs and the reduction of pollution.

These and other aims are therefore reached with the present cylinder assembly for an engine, as per claim 1.

Such a cylinder (1) forms a combustion chamber (50) and, in accordance with the invention, at least a photovoltaic surface (60) is further foreseen, arranged in such a way as to result to be irradiated by the light produced as a consequence of a combustion that takes place inside of such a combustion chamber (50). In addition to this, at least an optical fiber is comprised passing through the combustion chamber in such a way as to be irradiated, in use, by the light emitted as a consequence of the combustion and, further, the photovoltaic surface is arranged externally to the combustion chamber in such a way as to be irradiated by the light transported by the optical fiber in exit from the cylinder. This solution solves easily all said technical problems.

In particular, the use of the solar panel allows to take advantage of the light emitted by the combustion for the production of current. Without such solar panels, the light would result unused and the production of electric energy, as discussed in the preamble of the background art, would be produced with complex mechanical systems or with recharge systems that are expensive for the user.

This solution, instead, in a simple and economical manner allows the production of electric current by simply taking advantage of the light generated by a combustion that takes place inside the engine during its normal use and making so that this light is precisely absorbed by specific photovoltaic panels.

The current is therefore produced in correspondence of the ignition of the vehicle, independently from the fact that it is still or in movement.

The electric current can then be stored in specific batteries or can be used to feed electric devices present in the vehicle such as the alternator or even an auxiliary electric engine. At least an optical fiber (10) is foreseen, passing through said combustion chamber (50) in such a way as to be irradiated, in use, by the light emitted as a consequence of said combustion and wherein, further, said photovoltaic surface (60) is arranged externally to the combustion chamber in such a way as to be irradiated by the light transported by said optical fiber (10) in exit from the cylinder.

Advantageously, a passing hole (2) can be foreseen in the cylinder (1) through which the optical fiber (10) enters in the combustion chamber (50) and exits from the cylinder.

Advantageously, a transparent conduit (11) can be foreseen, arranged in such a way as to go through the cylinder (1), through the combustion chamber (50), the optical fiber passing inside said conduit (11).

Advantageously, said conduit (11) can be placed through the passing hole (2).

Advantageously, the passing hole (2) can be threaded and the external surface of the conduit (11) presents a complementary thread that allows to screw the conduit (11) in the passing hole (2).

Advantageously, in all the solutions described, the photovoltaic surface can be protected by a layer of transparent material resistant to heat, preferably glass brick.

Advantageously, the photovoltaic surface (60) produces electric current and is suitable for connecting to an external electric device-(70).

Advantageously, two photovoltaic surfaces (60', 60") and a layer (200) of transparent material interposed between said two surfaces (60', 60") can be foreseen, the optical fiber going through said layer (200) in such a way as to result comprised between said two photovoltaic surfaces (60', 60").

It is also described here the engine that foresees the type of cylinder assembly described above.

Advantageously, a passing hole (2) can be foreseen in the cylinder (1) through which the optical fiber (10) enters in the combustion chamber (50) and exits from the cylinder.

Advantageously, a transparent conduit (1) can be foreseen, arranged in such a way as to go through the cylinder (1) through the combustion chamber (50), the optical fiber passing inside said conduit (11).

Advantageously, the conduit (11) can be placed through the passing hole (2).

Advantageously, the passing hole (2) can be threaded and the external surface of the conduit (11) presents a complementary thread that allows to screw the conduit (11) in the passing hole (2).

Advantageously, the at least one photovoltaic surface can be protected by a layer of transparent material resistant to heat, preferably glass brick.

Advantageously, the photovoltaic surface (60) produces electric current and is suitable for connecting to an external electric device (70).

Advantageously, two photovoltaic surfaces (60', 60'') and a layer (200) of transparent material interposed between said two surfaces (60', 60'') can also be foreseen, the optical fiber passing through said layer (200) in such a way as to result to be comprised between said two photovoltaic surfaces (60', 60'').

### Brief description of drawings

Further features and advantages of the present invention will result clearer with the description that follows of some embodiments, made to illustrate but not to limit, with reference to the annexed drawings, wherein:
- Figure 1 shows schematically a cylinder 1 inside of which a piston 6 is placed slidingly and provided with a passing hole for an optical fiber;
- Figure 2 shows a top assembly view of more cylinders put side by side and gone through each one by an optical fiber;
- Figure 3 shows a detail of the optical fiber 10 which passes inside of a conduit 11 of containment of the transparent type;
- Figure 4 schematizes the phase of ignition through the spark off of the spark and the consequent explosion which frees the light that is captured by the optical fiber passing through the combustion chamber 50;
- Figure 5 shows the optical fiber connected to a solar panel 60 installed in the vehicle and whose electric current produced can be used for many uses in the vehicle, for example, the activation of the alternator and the activation of an electric engine of aid to the internal combustion engine;
- Figure 6 shows, last, a constructive solution with two overlapped panels and having a layer of transparent material interposed into which the optical fibers pass.

### Description of some preferred embodiments

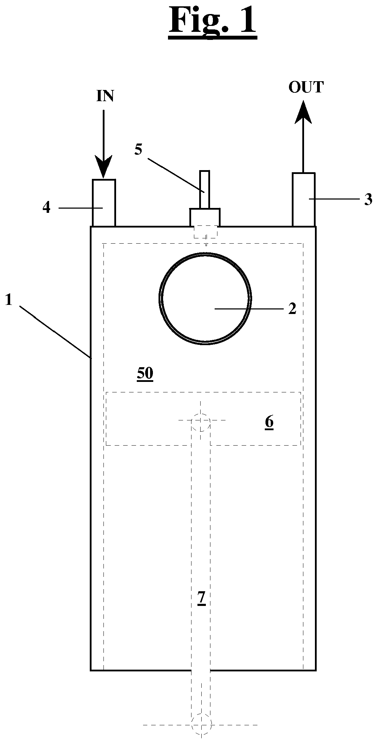

Figure 1 shows a cylinder of an internal combustion engine in accordance with the invention.

The cylinder 1 forms inside of it a combustion chamber 50, inside of which a piston 6 is slidingly arranged, hinged to a piston rod 7. The alternate sliding motion of the piston 6 activates the piston rod that transforms this alternate motion in a rotatory motion for the axis to which the piston rod itself results to be connected.

Figure 1, just for clarity purposes, shows with a thin dotted line the piston 6, the piston rod 7 and the walls that delimit the cylinder and in respect of which the piston 6 slides.

Always in figure 1 the inlets 4 (IN) are shown for the air-fuel mixture and the outlet 3 (OUT) for the expulsion of the combusted gases. It is then shown the spark plug 5 that triggers the ignition, as it is well known in the state of the art.

In accordance with the invention, figure 1 shows an opening 2 of passage in the cylinder and that allows a passage from part to part of an optical fiber 10.

The opening is placed above the superior dead point, that is in a position that is not reached by the piston during its working cycle.

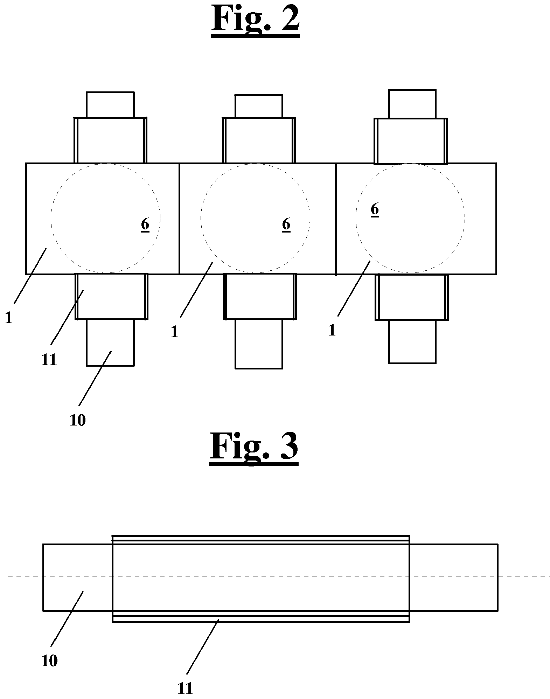

As shown in figure 3, a conduit 11 is foreseen that serves for the containment of the optical fiber in its passage through the cylinder.

The conduit 11 can be of any shape but, preferably, of the cylindrical type.

The conduit is realized in a material transparent to light and such as to resist to the temperatures inside of a cylinder for internal combustion engine.

A possible idoneous material for these purposes can for example be the glass brick.

The conduit 11 therefore presents externally a thread in such a way as to be screwed inside the passing hole 2, in turn provided with complementary thread.

The hole 2 of passage is naturally placed in axis with a second hole to allow, from the opposite part of the cylinder, the exit of the conduit 11 and therefore the passage of the optical fiber.

The top view of figure 2 highlights well an assembly of three cylinders 1 and the conduit 11 passing in the cylinder from part to part with the optical fiber that passes inside of it.

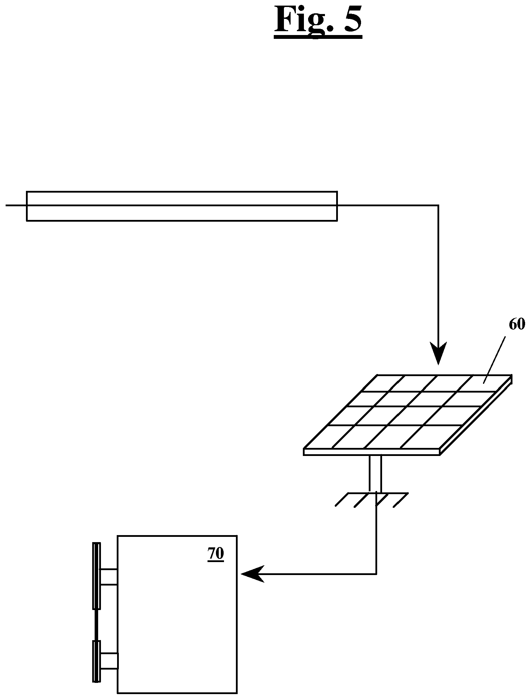

As it is then schematized in figure 5, the optical fiber results communicating with a system of photovoltaic paneling 60 in such a way as to irradiate it with the light that it transports.

In that sense, the optical fiber is a physical channel to transport the light produced by the combustion inside of the cylinder to take it externally to an idoneous system of solar panels.

Solar panels are well known in the state of the art and are constituted by photovoltaic cells which, when irradiated by light, produce electric current.

Being well known in the state of the art, solar panels will not be further described in detail here.

The electric current produced by the system can be useful for many purposes inside of the vehicle where it is installed.

For example, figure 5 schematizes an electric engine 70 which is fed by the current produced by the photovoltaic panel at each internal combustion cycle and therefore that can in turn be used as an aid to the internal combustion engine or as reserve electric engine.

Alternatively, for example, the current produced could be stored in a battery to be re-used subsequently or to feed an alternator.

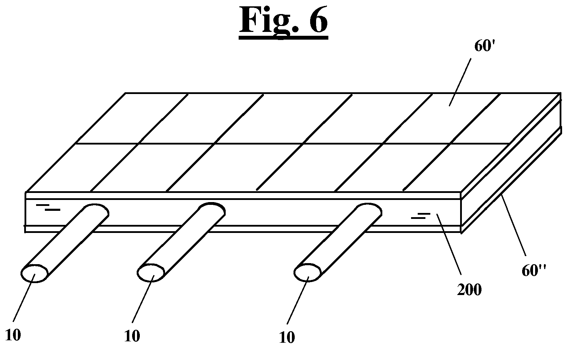

Going on with the structural description of the invention, figure 6 shows a preferred embodiment of the invention.

In this case, a superior photovoltaic panel 60' and an inferior photovoltaic panel 60" are foreseen. Interposed between said two photovoltaic panels a layer 200 of transparent material is foreseen, which allows the passage of the optical fibers 100.

The layer 200 interposed can for example be in glass-ceramic or in a transparent material of the plexiglass type.

This solution has the advantage that the light transported is used almost completely since two opposed photovoltaic surfaces are easily irradiated.

A contour frame can be foreseen in a highly reflecting material, such as a mirror, so as to eliminate the lateral losses directed laterally from the optical fibers and make that these lateral luminous beams are again directed towards the panels. In this manner, the absorption of the light by the panels is maximized.

The photovoltaic surfaces can be positioned in any convenient point inside the vehicle.

For example, the solution of figure 6 lends itself well to an installation below the hood of the vehicle where precisely the engine compartment is arranged.

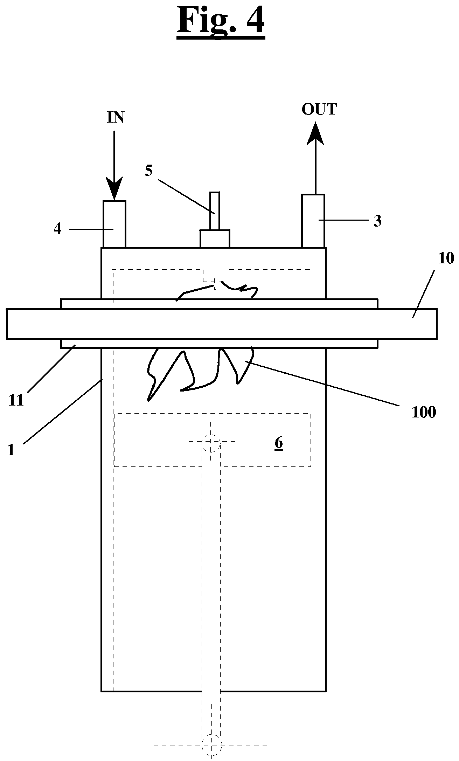

With reference to figure 4, in use, the functioning is the following.

The figure shows the passage of the optical fiber through the channel formed by the conduit 11 in a material transparent to light. The conduit 11 passes from part to part of the cylinder through the holes 2 in axis.

At each functioning cycle of the engine, that is every time the trigger of a spark 100 from the spark plug takes place and therefore the consequent explosion, the optical fiber is irradiated by the light generated from the burst and will transport this light to the photovoltaic surface/s, consequently irradiating them.

The photovoltaic surfaces, in turn, will be capable of producing electric current usable for the most varied purposes.

Just as a way of example, not limiting, some examples are mentioned below.

A four-cylinder engine working at a regime of 4.000 r/min produces 16.000 luminous beams/min that are transported and that irradiate the photovoltaic surfaces. On the basis of the size of the engine and of the photovoltaic panels used, it is obvious that a huge quantity of energy can be produced.

In a variant the conduit 11 could be integral to the cylinder but the screwed solution has the advantage of allowing an easy disassembly both for the maintenance and for the periodic cleaning. Dirt residues could obscure the conduits themselves and therefore reduce the quantity of light that hits the optical fibers themselves. The conduit 11 could also be inserted by mechanical interference.

In a further variant of the invention, the passage of the optical fibers could take place without the aid of the conduits 11 if it is possible to select a type of fiber capable of resisting to the internal temperatures.

In a cylinder assembly not in accordance with the invention, it could be possible to foresee the application of a photovoltaic surface directly in the combustion chamber. For example, photovoltaic micro-panels can be applied directly in the walls forming the combustion chamber. Alternatively, a photovoltaic varnish can be used, applied on the internal wall of the combustion chamber. These solutions would require the protection of the panel with a transparent layer, for example of glass brick, to maintain integral the panel despite the high temperatures.

This solution has the advantage of not requiring the use of optical fibers but, obviously, the operation of cleaning of the photovoltaic panels results extremely complex, operation that is necessarily required to ensure that the absorption surface of the light is always the maximum. It is obvious that this solution, although possible, would require a periodical disassembly of the cylinders of the engine. Moreover, the size of the combustion chamber is minimum and therefore also the internal photovoltaic surface that can be placed is really minimum.

The solution with the optical fibers, instead, allows to place the panels in points of easy access for cleaning, in addition to allow the realization of photovoltaic surfaces not bound anymore to the restricted size of a combustion chamber formed by a classical cylinder.

Although the invention has been described with particular reference to the internal combustion engine, it is obvious that the same results equally applicable to all those engines in which an explosion takes place, not necessarily triggered by a spark plug as in the internal combustion engine described.

In that sense, for example, the same technology can without problems be applied to the diesel engine in which the explosion is not obtained through a spark generated by the spark plug but, rather, through a high value of pressure with which the piston compresses the mixture of air-diesel inside of the combustion chamber.

It is obvious that this technology lends itself well to any type of engine with cylinders in which a combustion takes place and therefore an explosion with emission of light (therefore also LPG or methane).

Obviously, the production and selling of the single cylinder as described is possible, to then mount it on a specific engine, or the integral realization of an engine is possible that is born already with said cylinders as described.

## Claims

1. A cylinder assembly (1) for an engine, the cylinder forming a combustion chamber (50) and wherein at least a photovoltaic surface (60) is comprised, arranged in such a way as to result irradiated by the light produced as a consequence of a combustion that takes place in the combustion chamber (50), **characterized in that** at least an optical fiber (10) is further comprised passing through said combustion chamber (50) in such a way as to be irradiated, in use, by the light emitted as a consequence of said combustion and wherein, further, said photovoltaic surface (60) is arranged externally to the combustion chamber in such a way as to be irradiated by the light transported by said optical fiber (10) in exit from the cylinder.

2. A cylinder assembly, as per claim 1, wherein a passing hole (2) in the cylinder (1) is comprised, through which the optical fiber (10) enters in the combustion chamber (50) and exits from the cylinder.

3. A cylinder assembly, as per one or more of the preceding claims, wherein a transparent conduit (11) is comprised, arranged in such a way as to go through the cylinder (1), through the combustion chamber (50), the optical fiber passing inside said conduit (11).

4. A cylinder assembly, as per one or more of the preceding claims, wherein said conduit (11) is placed through the passing hole (2).

5. A cylinder assembly, as per one or more of the preceding claims, wherein the passing hole (2) is threaded and the external surface of the conduit (11) presents a complementary thread that allows to screw the conduit (11) in the passing hole (2).

6. A cylinder assembly, as per claim 1, wherein said at least photovoltaic surface is protected by a layer of transparent material resistant to heat, preferably glass brick.

7. A cylinder assembly, as per one or more of the preceding claims, wherein two photovoltaic surfaces (60', 60") and a layer (200) of transparent material interposed between said two surfaces (60', 60") are foreseen, the optical fiber passing through said layer (200) in such a way as to result comprised between said two photovoltaic surfaces (60', 60").

8. An engine comprising at least a cylinder assembly as per claim 1.

9. An engine, as per claim 8, wherein a passing hole (2) is foreseen in the cylinder (1) through which the optical fiber (10) enters in the combustion chamber (50) and exits from the cylinder.

10. An engine, as per claim 8 or 9, wherein a transparent conduit (11) is comprised, arranged in such a way as to go through the cylinder (1) through the combustion chamber (50), the optical fiber passing inside said conduit (11).

11. An engine, as per one or more of the preceding claims from 8 to 10, wherein two photovoltaic surfaces (60', 60") and a layer (200) of transparent material interposed between said two surfaces (60', 60") are comprised, the optical fiber passing through said layer (200) in such a way as to result to be comprised between said two photovoltaic surfaces (60', 60").

## Patentansprüche

1. Zylinderbaugruppe (1) für einen Motor, wobei der Zylinder eine Verbrennungskammer (50) bildet und wobei mindestens eine Photovoltaikoberfläche (60) enthalten ist, so angeordnet, dass diese von Licht bestrahlt wird, das als eine Folge einer Verbrennung erzeugt wird, die in der Verbrennungskammer (50) stattfindet, **dadurch gekennzeichnet, dass** zudem mindestens eine Glasfaser (10) enthalten ist, die durch die Verbrennungskammer (50) führt, sodass sie in Verwendung durch das Licht bestrahlt wird, das als eine Folge der Verbrennung abgegeben wird, und wobei die Photovoltaikoberfläche (60) zudem außerhalb der Verbrennungskammer angeordnet ist, sodass sie durch das Licht bestrahlt wird, das die aus dem Zylinder austretende Glasfaser (10) transportiert.

2. Zylinderbaugruppe nach Anspruch 1, wobei ein Durchführungsloch (2) im Zylinder (1) enthalten ist, durch das die Glasfaser (10) in die Verbrennungskammer (50) eintritt und aus dem Zylinder austritt.

3. Zylinderbaugruppe nach einem der vorhergehenden Ansprüche, wobei eine transparente Leitung (11) enthalten ist, so angeordnet, dass sie durch den Zylinder (1) und durch die Verbrennungskammer (50) führt, wobei die Glasfaser durch diese Leitung (11) geführt wird.

4. Zylinderbaugruppe nach einem oder mehreren der vorhergehenden Ansprüche, wobei die Leitung (11) durch das Durchführungsloch (2) platziert ist.

5. Zylinderbaugruppe nach einem oder mehreren der vorhergehenden Ansprüche, wobei das Durchführungsloch (2) mit einem Gewinde versehen ist und die äußere Oberfläche der Leitung (11) ein dazu passendes Gewinde aufweist, was erlaubt, dass die Leitung (11) in das Durchführungsloch (2) eingeschraubt werden kann.

6. Zylinderbaugruppe nach Anspruch 1, wobei die mindestens eine Photovoltaikoberfläche durch eine Schicht aus hitzebeständigem, durchsichtigem Material, vorzugsweise Glasbaustein, geschützt ist.

7. Zylinderbaugruppe nach einem der vorhergehenden Ansprüche, wobei zwei Photovoltaikoberflächen (60', 60") und eine Schicht (200) aus durchsichtigem Material zwischen den zwei Oberflächen (60', 60") vorgesehen sind und die Glasfaser durch diese Schicht (200) führt, sodass sie zwischen den zwei Photovoltaikoberflächen (60', 60") umfasst ist.

8. Motor, umfassend mindestens eine Zylinderbaugruppe nach Anspruch 1.

9. Motor nach Anspruch 8, wobei ein Durchführungsloch (2) im Zylinder (1) vorgesehen ist, durch das die Glasfaser (10) in die Verbrennungskammer (50) eintritt und aus dem Zylinder austritt.

10. Motor nach Anspruch 8 oder 9, wobei eine transparente Leitung (11) enthalten ist, so angeordnet, dass sie durch den Zylinder (1) und durch die Verbrennungskammer (50) führt, wobei die Glasfaser durch diese Leitung (11) geführt wird.

11. Motor nach einem oder mehreren der vorhergehenden Ansprüche 8 bis 10, wobei zwei Photovoltaikoberflächen (60', 60") und eine Schicht (200) aus durchsichtigem Material zwischen den zwei Oberflächen (60', 60") umfasst sind und die Glasfaser durch diese Schicht (200) führt, sodass sie zwischen den zwei Photovoltaikoberflächen (60', 60") umfasst ist.

## Revendications

1. Ensemble cylindre
(1) pour un moteur, le cylindre formant une chambre de combustion (50) et dans lequel est comprise au moins une surface photovoltaïque (60), disposée de façon à être irradiée par la lumière produite suite à une combustion ayant lieu dans la chambre de combustion (50), **caractérisé en ce qu'**au moins une fibre optique (10) est en outre comprise passant à travers ladite chambre de combustion (50) de façon à être irradiée, lors de l'utilisation, par la lumière émise suite à ladite combustion et dans lequel, en outre, ladite surface photovoltaïque
(60) est
disposée à l'extérieur de la chambre de combustion de façon à être irradiée par la lumière transportée par ladite fibre optique (10) sortant du cylindre.

2. Ensemble cylindre,
selon la revendication 1, dans lequel est compris un trou traversant (2) dans le cylindre (1), à travers lequel la fibre optique (10) entre dans la chambre de combustion (50) et sort du cylindre.

3. Ensemble cylindre,
selon une ou plusieurs des revendications précédentes, dans lequel est compris un conduit transparent (11), disposé de façon à passer par le cylindre (1), à travers la chambre de combustion (50), la fibre optique passant à l'intérieur dudit conduit (11).

4. Ensemble cylindre,
selon une ou plusieurs des revendications précédentes, dans lequel ledit conduit (11) est placé à travers le trou traversant (2).

5. Ensemble cylindre,
selon une ou plusieurs des revendications précédentes, dans lequel le trou traversant (2) est fileté et la surface externe du conduit (11) présente un filetage complémentaire qui permet de visser le conduit (11) dans le trou traversant (2).

6. Ensemble cylindre,
selon la revendication 1, dans lequel au moins ladite surface photovoltaïque est protégée par une couche de matériau transparent thermorésistant, de préférence de la brique de verre.

7. Ensemble cylindre,
selon une ou plusieurs des revendications précédentes, dans lequel deux surfaces photovoltaïques (60', 60") et une couche (200) de matériau transparent interposée entre lesdites deux surfaces (60', 60") sont prévues, la fibre optique passant à travers ladite couche (200) de façon à être comprise entre lesdites deux surfaces photovoltaïques (60', 60").

8. Moteur comprenant au moins un ensemble cylindre selon la revendication 1.

9. Moteur, selon la revendication 8, dans lequel un trou traversant (2) est prévu dans le cylindre (1) à travers lequel la fibre optique (10) entre dans la chambre de combustion (50) et sort du cylindre.

10. Moteur, selon la revendication 8 ou 9, dans lequel est compris un conduit transparent (11), disposé de façon à passer par le cylindre (1) à travers la chambre de combustion (50), la fibre optique passant à l'intérieur dudit conduit (11).

11. Moteur, selon une ou plusieurs des revendications précédentes de 8 à 10, dans lequel deux surfaces photovoltaïques (60', 60") et une couche (200) de matériau transparent interposée entre lesdites deux surfaces ((60', 60") sont comprises, la fibre optique passant à travers ladite couche (200) de façon à être comprise entre lesdites deux surfaces photovoltaïques (60', 60") .
